# EUROPÄISCHE PATENTANMELDUNG

(11) **EP 1 045 445 A2**
(43) Veröffentlichungstag der Anmeldung: **18.10.2000**
(21) Anmeldenummer: 00107870.8
(22) Anmeldetag: 12.04.2000
(51) Int. Cl.: H01L 27/08

(54) **In einer integrierten Halbleiterschaltung gebildeter weitgehend spannungsunabhängiger elektrischer Widerstand**

(30) Priorität: 16.04.1999 DE 19917370
(71) Anmelder: STMicroelectronics GmbH, 85630 Grasbrunn (DE)
(72) Erfinder: Viebach, Michael, 83059 Kolbermoor (DE)
(74) Vertreter: Hirsch, Peter

(57) **Zusammenfassung**

In einer integrierten Halbleiterschaltung integrierter elektrischer Widerstand, aufweisend: einen Nutzwiderstand mit zwei voneinander beabstandeten Nutzwiderstandsanschlußkontaktzonen (21,27) und einer dazwischen befindlichen Nutzwiderstandszone (17,19) aus Halbleitermaterial; und einen Hilfswiderstand mit zwei voneinander beabstandeten Hilfswiderstandsanschlußkontaktzonen (29,29a) und einer dazwischen befindlichen Hilfswiderstandszone (13); wobei die Hilfswiderstandszone (13) in unterhalb der Nutzwiderstandszone (17,19) befindlichem Halbleitermaterial gebildet ist; zwischen Nutzwiderstandszone (17,19) und Hilfswiderstandszone (13) eine Zwischenzone (41,43) vorhanden ist; die Nutzwiderstandszone (17,19) und die Hilfswiderstandszone (13) eine im wesentlichen übereinstimmende Topographie aufweisen; und die Hilfswiderstandsanschlußkontaktzonen (29, 29a) und die Nutzwiderstandsanschlußkontaktzonen (21, 27) derart beschaltet sind, daß bei Anschluß der Halbleiterschaltung an eine Versorgungsspannungsquelle die Hilfswiderstandsanschlußkontaktzone (29) an einem Ende der Hilfswiderstandszone (13) und die Hilfswiderstandsanschlußkontaktzone (29a) am anderen Ende der Hilfswiderstandszone (13) je die gleiche Potentialdifferenz gegenüber der je benachbarten Nutzwiderstandsanschlußkontaktzone (21, 27) aufweisen.

## Beschreibung

Die Erfindung betrifft einen elektrischen Widerstand, der in einer integrierten Halbleiterschaltung gebildet ist.

Dieser elektrische Widerstand soll insbesondere in einer Widerstandskette Verwendung finden, wie sie beispielsweise zur Dämpfung oder Verstärkung von Audiosignalen verwendet wird.

Integrierte Widerstände werden durch Widerstandszonen aus Halbleitermaterial gebildet, die sich zwischen voneinander beabstandeten Anschlußkontakten erstrecken. Eine Widerstandszone kann eine Diffusionszone eines ersten Leitfähigkeitstyps sein, welche in die Oberfläche einer diffundierten oder implantierten Tasche des entgegengesetzten Leitfähigkeitstyps diffundiert ist. Ein Beispiel hierfür zeigt die DE 35 26 461 A1. Die Widerstandszone kann auch eine Diffusionszone eines ersten Leitfähigkeitstyps sein, welche in die Oberfläche einer Epitaxietasche des entgegengesetzten Leitfähigkeitstyps diffundiert ist. Beispiele hierfür zeigen die EP 0 001 574 A1 und die EP 0 017 919 A1. Außerdem kann die Widerstandszone durch eine Epitaxietasche eines ersten Leitfähigkeitstyps gebildet sein, welche auf einem Substrat des entgegengesetzten Leitfähigkeitstyps gebildet ist. In allen Fällen besteht zwischen der Widerstandszone und dem darunter befindlichen Halbleitermaterial ein pn-Übergang. Das unter der Widerstandszone befindliche Halbleitermaterial wird mit einem derartigen Potential beaufschlagt, daß zwischen der Widerstandszone und dem darunter befindlichen Halbleitermaterial bei allen an die Anschlußkontakte der Widerstandszone angelegten Spannungen sichergestellt ist, daß der pn-Übergang zwischen der Widerstandszone und dem darunter befindlichen Halbleitermaterial in Sperrichtung vorgespannt ist und dadurch zwischen der Widerstandszone und dem darunter befindlichen Halbleitermaterial zur Isolation eine an Ladungsträgern verarmte Raumladungszone gebildet wird. Bei sich ändernder Differenz zwischen dem Potential, das in der Widerstandszone auftritt, und dem Potential, das in dem darunter befindlichen Halbleitermaterial auftritt, ändert sich die Weite (Ausdehnung) der Raumladungszone, was sich auf den Widerstandswert des integrierten Widerstandes und auf den Spannungsabfall entlang der Widerstandszone des integrierten Widerstandes auswirkt.

Die EP 001 574 befaßt sich mit diesem Problem nicht. Diese Druckschrift offenbart eine hinsichtlich ihrer endgültigen Verwendbarkeit flexible Halbleiterstruktur, bei welcher in eine auf einem Substrat befindliche N⁻-Epitaxieschicht zunächst eine P⁺-Zone und in deren Oberfläche eine N⁻-Zone eingebracht wird. Je nach Kontaktierungsart kann die in der Epitaxieschicht erhaltene Drei-Schicht-Struktur zur Realisierung eines Transistors oder zur Realisierung zweier übereinander liegender Widerstände, die durch die mittlere Schicht voneinander getrennt sind, verwendet werden. Widerstandsänderungen, die bei sich änderndem Potential aufgrund der sich entsprechend ändernden zugehörigen Raumladungszone entstehen, werden bei dieser bekannten Struktur nicht vermieden.

Auch die DE 35 26 461 A1 befaßt sich nicht mit dem genannten Problem. Bei dieser Druckschrift wird der Abhängigkeit der Linearität des Teilerverhältnisses einer integrierten Widerstandskette von den Kontaktwiderständen der Kontaktierungszonen der einzelnen Widerstände der Widerstandskette dadurch begegnet, daß die einzelnen Widerstände nicht in einer einzigen gemeinsamen Widerstandsbahn gebildet sind sondern jeder einzelne Widerstand in einer gesonderten Widerstandsbahn mit zwei Anschlußkontaktzonen gebildet ist.

Bei der aus der EP 0 017 919 A1 bekannten Halbleiterstruktur wird die Abhängigkeit eines integrierten Widerstandes von Änderungen der den Widerstand isolierenden und von Potentialänderungen abhängigen Raumladungszone dadurch verringert, daß der Widerstand durch zwei in Reihe geschaltete Widerstandszonen gebildet wird, denen je eine eigene Isolierzone einer unter den Widerstandszonen befindlichen epitaktischen Schicht zugeordnet ist, die beide mit unterschiedlichem Potential beaufschlagt werden. Dabei wird eine derartige Potentialaufschlagung der einzelnen Widerstandszonen und der einzelnen Isolierzonen vorgenommen, daß sich im Fall einer Änderung der an die beiden Widerstandszonen angelegten Spannung eine Widerstandsverringerung der einen Widerstandszone und eine Widerstandserhöhung der anderen Widerstandszone kompensieren.

Wird der integrierte Widerstand zur Dämpfung eines Wechselspannungssignals, beispielsweise Audiosignais, verwendet, ändert sich die Potentialdifferenz zwischen der Widerstandszone und dem darunter liegenden Halbleitermaterial entsprechend dem an die Widerstandszone angelegten Wechselpotential. Dies bewirkt eine entsprechende Modulation der am pn-Übergang gebildeten Raumladungszone. Dies wiederum bewirkt eine Modulation des Widerstandswertes des integrierten Widerstandes und des Spannungsabfalls entlang der Widerstandszone. Im Fall der Verwendung des integrierten Widerstandes zur Dämpfung eines Audiosignals entsteht dadurch Klirren mit einem bestimmten Klirrfaktor.

Eine Verringerung dieses Klirrfaktors hat man durch integrierte Widerstände erreicht, deren Widerstandszone durch eine Schicht aus polykristallinem Silizium gebildet ist, das sich auf einer Isolierschicht, vorzugsweise Oxidschicht, befindet, die meistens auf der Oberfläche einer Epitaxietasche oder direkt auf dem Substrat gebildet ist. Bei veränderlicher Potentialdifferenz zwischen dieser Widerstandszone und dem darunter befindlichen Halbleitermaterial kommt es auch im Fall eines derartigen integrierten Widerstandes zu einer Beeinträchtigung des integrierten Widerstandes, insbesondere zu einer Widerstandsmodulation im Fall von Wechselspannungen und zu Klirren im Fall von Audiosignalen. Dies deshalb, weil es infolge von feldstärkeabhängiger Einwirkung auf die zur Oxidschicht weisende Unterseite der polykristallinen Widerstandszone zu Ladungsträgerkonzentrationen kommt, die sich mit der Potentialdifferenz zwischen der Widerstandszone und dem unter dem Oxid befindlichen Halbleitermaterial ändern. Dieser Mechanismus ist vergleichbar mit der Auswirkung des Gate-Potentials eines MOS-Transistors auf die unter dem Gate-Oxid befindliche Kanalzone.

In einer praktisch ausgeführten herkömmlichen integrierten Audioschaltung, in welcher derartige Widerstände aus polykristallinem Silizium mit einer Spannungsabhängigkeit von ca. 100 ppm verwendet werden, wurde in Audiospannungsteilern mit 6 dB Dämpfung bei 1 Vrms am Eingang des Teilers ein Klirrfaktor von 0,004 % am Ausgang des Teilers erreicht. Noch etwas bessere Ergebnisse erhält man bei Verwendung von Widerständen, deren Widerstandszone aus einer oxidisolierten Silizium-Chrom-Schicht besteht. Die Herstellung solcher Silizium-Chrom-Widerstände ist jedoch sehr aufwendig und teuer.

Wenn auch integrierte Widerstände mit Widerstandszonen in Form von polykristallinen Siliziumschichten oder Silizium-Chrom-Schichten zu einem geringeren Klirrfaktor führen als integrierte Widerstände in Form von diffündierten Widerstandszonen oder in Form von epitaktischen Widerstandszonen, gibt es Anwendungen, für welche man mit dem Klirrfaktor unter einen Wert herabkommen möchte, der noch deutlich niedriger ist als derjenige Klirrfaktor, den man mit polykristallinen bzw. Silizium-Chrom-Widerstandszonen erreichen kann.

Dies kann man erfindungsgemäß dadurch erreichen, daß man in dem Halbleitermaterial unterhalb der Nutzwiderstandszone eine zusätzliche Hilfswiderstandszone bildet, derart, daß entlang der Nutzwiderstandszone und entlang der Hilfswiderstandszone ein gleichartiger Spannungsabfallverlauf entsteht.

Ein nach diesem Prinzip aufgebauter integrierter Widerstand ist im Patentanspruch 1 angegeben. Eine erfindungsgemäße Widerstandskette mit derartigen Widerständen ist im Anspruch 14 angegeben. Eine erfindungsgemäße Analogsignal-Dämpfungsschaltung und eine Audiosignal-Dämpfungsschaltung mit einer derartigen Widerstandskette sind in Anspruch 27 bzw. 29 angegeben.

Ausgestaltungen dieser erfindungsgemäßen Lösungen sind in den abhängigen Ansprüchen angegeben.

Ein erfindungsgemäßer integrierter Widerstand weist einen Nutzwiderstand mit zwei voneinander beabstandeten Nutzwiderstandsanschlußkontaktzonen für den Anschluß von Nutzwiderstandskontakten und einer dazwischen befindlichen Nutzwiderstandszone aus Halbleitermaterial auf. Ein Hilfswiderstand mit zwei voneinander beabstandeten Hilfswiderstandsanschlußkontaktzonen für den Anschluß von Hilfswiderstandsanschlußkontakten und einer dazwischen befindlichen Hilfswiderstandszone befindet sich im Halbleitermaterial unterhalb der Nutzwiderstandszone. Die Nutzwiderstandszone und die Hilfswiderstandszone sind durch eine elektrisch trennende Zwischenzone voneinander getrennt. Die Nutzwiderstandszone und die Hilfswiderstandszone weisen eine im wesentichen übereinstimmende Topographie auf. Die Hilfswiderstandsanschlußkontaktzonen sind jeweils mit dem gleichen elektrischen Potential wie die je benachbarten Nutzwiderstandsanschlußkontaktzonen verbunden, oder zur verbesserten Isolation ist deren Potential jeweils um die gleiche Gleichspannungspotentialdifferenz verschoben.

Ohne Anwendung einer Potentialverschiebung und bei exakt übereinstimmender Topographie von Nutzwiderstandszone und Hilfswiderstandszone entsteht an allen Stellen entlang der Nutzwiderstandszone eine Potentialdifferenz null zwischen der Nutzwiderstandszone und der Hilfswiderstandszone. Beim Anlegen einer Wechselspannung sowohl an den Nutzwiderstand als auch an den Hilfswiderstand kommt es zwar zu dem Wechselspannungsverlauf entsprechenden zeitlichen Änderungen der Potentialwerte in der Nutzwiderstandszone und in der Hilfswiderstandszone. Die Potentialdifferenz zwischen Nutzwiderstandszone und Hilfswiderstandszone bleibt jedoch zu allen Zeiten und an allen Stellen entlang der Nutzwiderstandszone annähernd gleich. Widerstandsänderungen und Widerstandsmodulationen treten daher im Nutzwiderstand kaum auf. Widerstandsänderungen im Hilfswiderstand treten jedoch auf wegen der sich ändernden Potentialdifferenz zwischen Hilfswiderstand und dem darunterliegenden Substrat. Die Widerstandsänderung durch Spannungsabhängigkeit wird also quasi vom Nutzwiderstand in den Hilfswiderstand verlagert, wo sie keine nachteiligen Auswirkungen hat.

Im Fall von integrierten Widerständen, bei welchen die Nutzwiderstandszone von der Hilfswiderstandszone durch einen pn-Übergang voneinander getrennt ist, reicht es zur elektrischen Trennung zwischen Nutzwiderstandszone und Hilfswiderstandszone aus, wenn über dem pn-Übergang eine Sperrvorspannung liegt, also eine Vorspannung, die niedriger ist als die Schwellenspannung, bei welcher der pn-Übergang in den leitenden Zustand gelangt. Die Potentialdifferenz über dem pn-Übergang darf also null sein, wie es der Fall ist, wenn die Topographien von Nutzwiderstandszone und Hilfswiderstandszone exakt übereinstimmen und wenn die Hilfswiderstandsanschlußkontakte und die je benachbarten Nutzwiderstandsanschlußkontakten auf gleiches Potential gelegt werden. Es muß aber in jedem Fall vermieden werden, daß an dem pn-Übergang eine Spannungsdifferenz auftritt, welche den pn-Übergang in den leitenden Zustand bringt. Zwar genügt die Potentialdifferenz null zur Isolation, aber dabei ist zu beachten, daß bei diffundierten Widerständen gerade im Bereich kleiner Sperrspannungen die größte Spannungsabhängigkeit besteht und sich kleine Fehler im Spannungsabfallverlauf des Hilfswiderstandes doch noch merklich auswirken können.

Bei praktischen Ausführungsformen wird der Idealfall, daß die Nutzwiderstandszone und die Hilfswiderstandszone exakt übereinstimmende Topographien aufweisen, meist nicht erreicht werden. Dies führt zu gewissen Abweichungen der Spannungsabfallverläufe von Nutzwiderstandszone einerseits und Hilfswiderstandszone andererseits voneinander. Insbesondere, wenn man aus Herstellungsgründen größere Abweichungen zwischen den Topographien von Nutzwiderstandszone und Hilfswiderstandszone zulassen möchte oder muß und die damit einhergehenden Abweichungen der Spannungsabfallverläufe von Nutzwiderstandszone und Hilfswiderstandszone voneinander, kann man zwischen den Nutzwiderstandsanschlußkontaktzonen und den je benachbarten Hilfswiderstandsanschlußkontaktzonen je eine Gleichspannungsquelle mit identischer Spannung vorsehen, anstatt die Hilfswiderstandsanschlußkontaktzonen mit dem gleichen Potential wie die Nutzwiderstandsanschlußkontaktzonen zu verbinden. Mittels dieser Gleichspannungsquelle wird der pn-Übergang zwischen Nutzwiderstandszone und Hilfswiderstandszone derart vorgespannt, daß auch bei Abweichungen der Spannungsabfallverläufe von Nutzwiderstandszone und Hilfswiderstandszone voneinander sichergestellt ist, daß der dazwischen befindliche pn-Übergang auf jeden Fall nicht in den leitenden Zustand gelangt und die Sperrspannung insgesamt größer wird und damit in dem Bereich geringerer Spannungsabhängigkeit liegt.

In Audioschaltungen kann man mit der Anwendung der erfindungsgemäßen Maßnahmen entweder bei gleichbleibender Herstellungstechnologie eine wesentliche Verringerung des Klirrfaktors erreichen oder man kann zu einer einfacheren Herstellungstechnologie übergehen, welche ohne die erfindungsgemäße Maßnahme zu einem schlechteren Klirrfaktor führen würde. Geht man beispielsweise von einem herkömmlichen integrierten Widerstand aus, dessen Widerstandszone durch eine polykristalline Siliziumschicht gebildet ist, kann man entweder durch Hinzufügen eines Hilfswiderstandes zu diesem polykristallinen Widerstand eine Verringerung des Klirrfaktors erreichen, wenn dies gefordert ist, oder man kann, wenn der mit dem herkömmlichen polykristallinen Widerstand erreichte Klirrfaktor ausreicht, auf beispielsweise einen diffundierten Widerstand übergehen und diesem einen Hilfswiderstand zuordnen. Wenn der Klirrfaktor nicht verbessert werden muß, ist ein solcher Technologiewechsel vorteilhaft, weil für diffundierte Widerstände Herstellungsprozesse verwendet werden können, bei welchen zusätzliche Masken, wie sie bei der Herstellung von polykristallinen Widerständen erforderlich sind, nicht benötigt werden. Wenn keine Klirrfaktorverbesserung gegenüber dem herkömmlichen polykristallinen Widerstand erforderlich ist, kann man durch Übergang zu einem diffundierten Nutzwiderstand mit zusätzlichem Hilfswiderstand zu geringeren Herstellungskosten kommen.

Die erfindungsgemäße Maßnahme, einem integrierten Nutzwiderstand einen integrierten Hilfswiderstand zuzuordnen, wirkt sich vorteilhaft bei Einzelwiderständen, insbesondere aber bei Widerstandsketten (für Widerstandsteiler/Spannungsteiler) aus. Besonders vorteilhaft ist die erfindungsgemäße Maßnahme bei Widerständen, die mit Wechselspannungssignalen, beispielsweise Audiosignalen, beaufschlagt werden, weil die Widerstandsmodulation durch das Wechselspannungssignal ganz oder weitestgehend ausgeschaltet wird. Die Erfindung wirkt sich aber auch vorteilhaft bei Widerständen aus, die nur mit Gleichspannungen beaufschlagt werden, insbesondere in Schaltungen, in denen hochpräzise Widerstandsverhältnisse erforderlich sind. Bei herkömmlichen Präzisionswiderstandsteilern mußte man entweder eine hochgenaue Widerstandstopographie sicherstellen und dabei die durch die Spannungsabhängigkeit veränderten Widerstandswerte berücksichtigen, oder die aus dem Herstellungsprozeß hervorgehenden Widerstände mittels Laserstrahlen trimmen. Beide Methoden führen zu entsprechend hohen Herstellungskosten.

Da ein erfindungsgemäß hergestellter integrierter Widerstand auch bei einfachen Herstellungsprozessen zu genauen spannungsunabhängigen Widerstandsverhältnissen führt, können solche kostentreibenden Maßnahmen vermieden werden.

Die Erfindung sowie weitere Aufgabenaspekte und Vorteile der Erfindung werden nun an Hand von Ausführungsformen näher erläutert.

In den Zeichnungen zeigen:
- Fig.1: ein Schaltbild eines Beispiels einer schaltbaren Widerstandskette, die mit erfindungsgemäßen Widerständen aufgebaut sein kann;
- Fig. 1a: ein Schaltbild eines Beispiels einer Widerstandskette aus nur zwei Nutzwiderständen mit dem räumlich darunter angeordneten Hilfswiderstand, der in diesem Fall zur Nutzwiderstandkette direkt parallel geschaltet ist;
- Fig. 1b: ein Schaltbild mit einem Beispiel einer Nutzwiderstandskette aus zwei Nutzwiderständen, bei dem der Hilfswiderstand zur Erhöhung der Sperrspannung über Gleichspannungsquellen parallel zur Nutzwiderstandskette geschaltet ist;
- Fig. 1c: ein Schaltbild mit einem Beispiel einer Widerstandskette aus zwei Nutzwiderständen bei dem der Hilfswiderstand zur Entkopplung über Spannungsfolger parallel geschaltet ist;
- Fig.2: eine Widerstandskette mit zwei diffundierten Widerständen herkömmlicher Art;
- Fig.3: einen Spannungsabfallverlauf entlang der beiden diffundierten Widerstände der Fig.2;
- Fig.4: ein Beispiel von Wechselspannungsverläufen, wie sie an verschiedenen Stellen entlang der beiden diffundierten Widerstände der Fig.2 auftreten;
- Fig.5: eine erfindungsgemäße Widerstandskette mit zwei diffundierten Nutzwiderständen und einem epitaktischen Hilfswiderstand;
- Fig.6: Spannungsabfallverläufe an den beiden Nutzwiderständen und an dem Hilfswiderstand der Fig.5;
- Fig. 6a: Spannungsabfallverläufe bei Anwendung der Maßnahmen nach Fig. 1a;
- Fig.7: Wechselspannungsverläufe an verschiedenen Stellen der in Fig.5 gezeigten Widerstandskette;
- Fig.8: eine Widerstandskette mit zwei epitaktischen Widerständen herkömmlicher Art;
- Fig.9: eine Widerstandskette mit zwei epitaktischen Nutzwiderständen und einem darunter befindlichen Hilfswiderstand der aus einer vergrabenen Schicht gebildet ist;
- Fig.10: eine Widerstandskette mit zwei polykristallinen Widerständen herkömmlicher Art;
- Fig.11: einen Spannungsabfallverlauf entlang den beiden polykristallinen Widerständen der Fig.10;
- Fig.12: eine erfindungsgemäße Widerstandskette mit zwei polykristallinen Nutzwiderständen und einem epitaktischen Hilfswiderstand;
- Fig.13: einen Spannungsabfallverlauf, wie er entlang der Widerstandskette gemäß Fig.12 auftritt;
- Fig.14: ein Beispiel einer Topographie der in Fig.10 gezeigten Widerstandskette herkömmlicher Art;
- Fig.15: ein Beispiel einer Topographie der in Fig.12 gezeigten Widerstandskette erfindungsgemäßer Art;
- Fig.16: ein Beispiel einer Topographie einer Widerstandskette mit einer größeren Anzahl polykristalliner Widerstände erfindungsgemäßer Art;
- Fig.17: die Topographie eines epitaktischen Hilfswiderstandes, wie er bei einer Widerstandskette erfindungsgemäßer Art gemäß Fig.16 verwendet werden kann;
- Fig.18: ein Beispiel einer Topographie einer Epitaxietasche, wie man sie für eine herkömmliche polykristalline Widerstandskette mit dem in Fig.16 gezeigten Topographie verwenden würde; und
- Fi.g 19: ein Schaltbild eines Beispiels für die Anwendung der Erfindung in einer Differenzstufe.

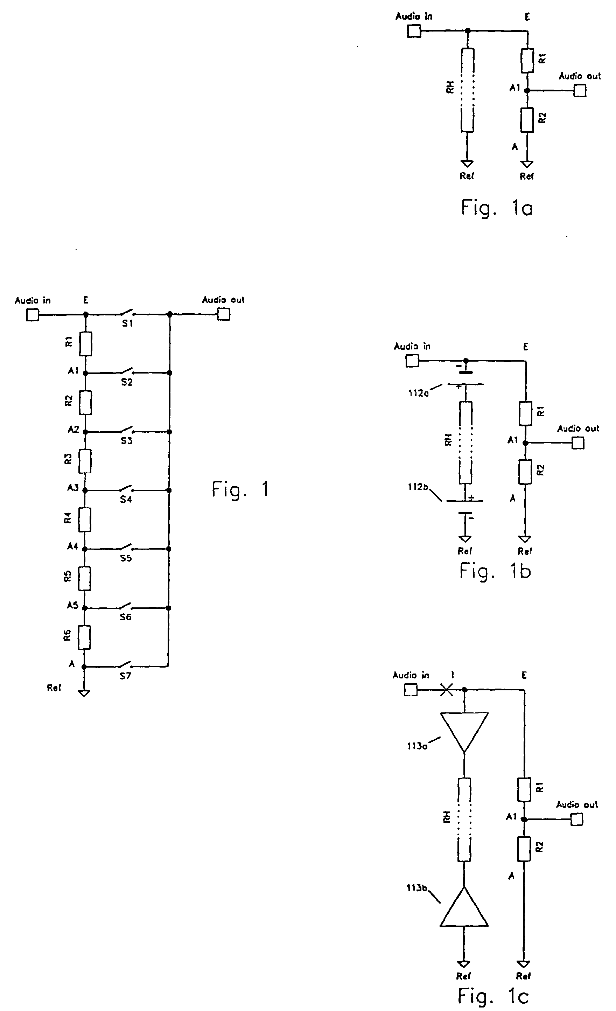

Fig. 1 zeigt ein Schaltbild einer beispielsweisen Widerstandskette mit sechs in Reihe geschalteten Widerständen R1 bis R6, zwischen denen fünf Abgriffe A1 bis A5 gebildet sind. Die Widerstandskette R1-R6 weist zwei Endanschlußkontakte auf, nämlich einen Eingangsanschlußkontakt E und einen Fußpunktanschlußkontakt A. Die beiden Endanschlußkontakte E und A sind an einen Audiosignaleingang "Audio In" bzw. einen Referenzspannungseingang Ref angeschlossen. Der Eingangsanschlußkontakt E, die Abgriffe A1-A5 und der Fußpunktanschlußkontakt A sind je über einen von sieben steuerbaren Schaltern S1-S7 mit einem Audiosignalausgang "Audio Out" verbunden. Je nach Dämpfungsbedarf für das Audiosignal wird einer der Schalter S1-S7 leitend gesteuert.

Derartige Widerstandsketten werden in Audiosignalverarbeitungsschaltungen beispielsweise im Eingangskreis oder im Rückkopplungskreis eines Operationsverstärkers eingesetzt, um das Audiosignal mit gewünschter Stärke dämpfen oder verstärken zu können.

Fig. 1a zeigt ein Schaltbild einer beispielsweisen Nutzwiderstandskette aus zwei Nutzwiderständen R1 und R2. Die Endanschlußkontakte E und A der Nutzwiderstandskette E sind an den Audiosignaleingang "Audio in" bzw. an die Referenzspannung "Ref" angeschlossen. Der räumlich unter der Nutzwiderstandskette gelegene Hilfswiderstand RH ist direkt parallel zur Nutzwiderstandskette an die Anschlüsse "Audio in" und "Ref" angeschlossen. Der Teilspannungsabgriff A1 der Nutzwiderstandskette R1, R2 ist an den Audiosignalausgang Audio out angeschlossen und hat keine Verbindung zum Hilfswiderstand RH. Die hochohmigen Bereiche des Hilfswiderstandes RH, die topologisch direkt unter den Nutzwiderständen R1 und R2 liegen und in denen der Hilfsspannungsabfall stattfindet, sind mit durchgezogenen Linien gezeichnet. Die niederohmigen Bereiche des Hilfswiderstands RH an denen kein Spannungsabfall stattfindet, weil sich der zugehörige Teil der Hilfswiderstandszone im Bereich einer milderohmigen vergrabenen Schicht befindet, sind gestrichelt gezeichnet.

Fig. 1b zeigt ein Schaltbild gemäß Fig. 1a, bei dem jedoch der Hilfswiderstand RH zur Erhöhung der Sperrspannung über Gleichspannungsquellen 112a und 112b parallel zur Nutzwiderstandskette R1, R2 geschaltet ist. Die beiden Quellen 112a, 112b weisen gleiche Spannungswerte auf. An jedem Ende des Hilfswiderstands RH befindet sich eine der beiden Gleichspannungsquellen 112a, 112b. Damit wird sichergestellt, daß die isolierende Raumladungszone zwischen den Nutzwiderständen R1 und R2 und dem darunter liegenden Hilfswiderstand RH auch bei ungenauer Topologie oder sonstigen Einflüssen erhalten bleibt. Zudem wird der widerstandsmodulierende Einfluß der Differenzspannung R1 und R2 zwischen Hilfswiderstand und Nutzwiderstand auf die Nutzwiderstände R1 und R2 geringer.

Fig. 1c zeigt ein Schaltbild gemäß Fig. 1a, bei dem zur Entkopplung der Hilfswiderstand RH über Spannungsfolger 113a, 113b angeschlossen ist, wobei sich an jedem Ende des Hilfswiderstandes RH je einer der Spannungsfolger 113a, 113b befindet. In diesem Fall bleiben der Strom I im Eingang "Audio in" und der Strom im Fußpunkt "Ref" unbeeinflußt vom Strom durch den Hilfswiderstand RH, welcher durch die eingangsspannungsabhängige Widerstandsmodulation beeinflußt ist. Diese Maßnahmen gemäß den Fig. 1b und 1c können auch zusammen angewendet werden.

In nachfolgenden Figuren werden schematisierte, nicht maßstabsgetreue, ausschnittsweise Schnittansichten solcher Teile von integrierten Halbleiterschaltungen gezeigt, in denen integrierte elektrische Widerstände gebildet sind. Dabei sind der Einfachheit halber Widerstandsketten mit nur zwei Widerständen dargestellt, obwohl praktische Ausführungsformen von Widerstandsketten in der Regel eine größere Anzahl von Widerständen aufweisen. Die in diesen Schnittdarstellungen gezeigten Kombinationen von Leitfähigkeitstypen der einzelnen Halbleiterzonen stellen lediglich Beispiele dar. Es kann jeweils auch die entgegengesetzte Kombination von Leitfähigkeitstypen gewählt werden.

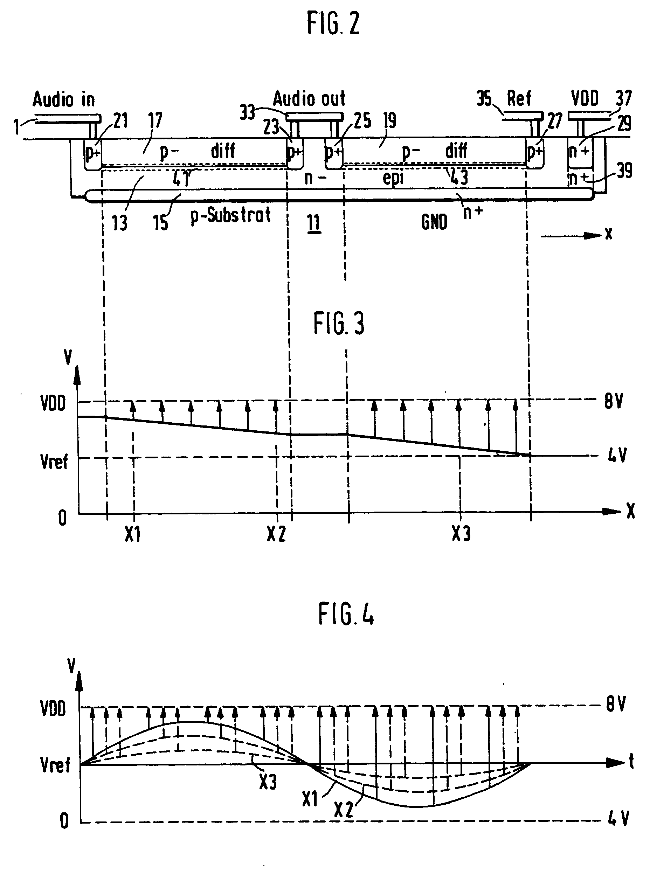

Fig. 2 zeigt eine Schnittansicht einer Widerstandskette mit zwei diffundierten Widerständen herkömmlicher Art. Dabei ist auf einem Substrat 11 mit p⁻-Leitfähigkeit eine Epitaxietasche 13 mit n⁻-Leitfähigkeit gebildet. In deren Bodenbereich ist eine vergrabene Schicht 15 mit n⁺-Leitfähigkeit gebildet. In die Oberfläche der Epitaxietasche 13 sind eine erste Widerstandszone 17 und eine zweite Widerstandszone 19 diffundiert, die je p⁻-Leitfähigkeit aufweisen. Die erste Widerstandszone 17 befindet sich zwischen zwei Anschlußkontaktzonen 21 und 23, während sich die zweite Widerstandszone 19 zwischen zwei Anschlußkontaktzonen 25 und 27 befindet. Jede der Anschlußkontaktzonen weist p⁺⁻-Leitfähigkeit auf. In einem außerhalb der beiden Widerstandszonen 17 und 19 liegenden Bereich ist die Epitaxietasche 13 mit einer Anschlußkontaktzone 29 mit n⁺-Leitfähigkeit versehen. Die Anschlußkontaktzonen 21 - 29 dienen der Kontaktierung der beiden Widerstandszonen 17 und 19 bzw. der Epitaxietasche 13 mit einer metallischen Leiterbahn oberhalb der Oberfläche des Substrates 11. Die Anschlußkontaktzone 21 ist mit einer metallischen Leiterbahn 31 verbunden, welche mit dem Audiosignaleingang Audio In verbunden ist. Die Anschlußkontaktzonen 23 und 25 sind gemeinsam mit einer metallischen Leiterbahn 33 verbunden, welche mit dem Audiosignalausgang Audio Out verbunden ist. Die Anschlußkontaktzone 27 ist mit einer metallischen Leiterbahn 35 verbunden, die mit der Referenzspannungsquelle Ref verbunden ist. Die Anschlußkontaktzone 29 ist mit einer metallischen Leiterbahn 37 verbunden, die der Zuführung einer positiven Versorgungsspannung VDD dient. Das Substrat 11 wird mit Massepotential GND beaufschlagt.

Zwischen der Anschlußkontaktzone 29 und der vergrabenen Schicht 15 befindet sich ein sogenannter Sinker 39, d.h. eine vertikale Verbindungszone hoher Leitfähigkeit, über welchen die vergrabene Schicht 15 und damit die gesamte Epitaxietasche 13 auf das Potential der Versorgungsspannungsquelle VDD gebracht wird.

Am pn-Übergang zwischen der Epitaxietasche 13 und der jeweiligen Widerstandszone 17 bzw. 19 bildet sich eine Raumladungszone 41 bzw. 43, deren Weite von der Potentialdifferenz zwischen der Epitaxietasche 13 und der jeweiligen Widerstandszone 17 bzw. 19 abhängt.

Fig. 3 zeigt einen Spannungabfallverlauf entlang den beiden Widerstandszonen 17 und 19 der in Fig. 2 gezeigten Widerstandskette. Dabei ist als Beispiel eine Versorgungsspannung VDD von 8 V, eine Massespannung von 0 V, eine dazwischen befindliche Referenzspannung Vref von 4 V und eine momentane Spannung von 7 V am Audiosignaleingang Audio In angenommen. Oberhalb des Spannungsabfallverlaufs sind Pfeile gezeigt, deren jeweilige Länge ein Maß für die Potentialdifferenz ist, die an der jeweiligen Stelle entlang der jeweiligen Widerstandszone 17 bzw. 19 am pn-Übergang wirksam ist. Da die Weite der Raumladungszone eines pn-Übergangs und die Ladungsträgeranfüllung bzw. Ladungsträgerverarmung der Raumladungszone von dem Wert der über dem pn-Übergang auftretenden Potentialdifferenz abhängt, haben die einzelnen Stellen entlang der Widerstandszonen 17 und 19 eine unterschiedliche Raumladungszonenweite und damit eine unterschiedliche effektive Weite der Widerstandsbahn.

Dies wirkt sich besonders nachteilig aus, wenn die Widerstände der Widerstandskette mit einer Wechselspannung, wie einem Audiosignal, beaufschlagt werden. Dies wird anhand von Fig. 4 erläutert. Dabei ist angenommen, daß dem Audiosignaleingang Audio In eine Sinusspannung zugeführt wird, von der in Fig. 4 eine zeitliche Periode dargestellt ist. Aufgrund des Spannungsabfalls entlang der beiden Widerstandszonen 17 und 19 wird dieses Audiosignal mit zunehmendem Abstand vom Audiosignaleingang Audio In immer schwächer. In Fig. 4 sind die Sinusverläufe an drei Stellen x1, x2 und x3 entlang der beiden Widerstandszonen 17 und 19 betrachtet. Die an den Stellen x1, x2 und x3 auftretenden Sinusverläufe sind mit einer durchgehenden Linie bzw. einer gestrichelten Linie bzw. einer gepunkteten Linie dargestellt. Oberhalb der Sinusverläufe sind Pfeile gezeigt, mit denen die zeitliche Änderung der Potentialdifferenz über den pn-Übergängen der beiden Widerstandszonen 17 und 19 an den drei Stellen x1 - x3 dargestellt sind. Diese Pfeile veranschaulichen, wie die Raumladungszonen und damit die Widerstände und Spannungabfallverläufe der beiden diffundierten Widerstände in Abhängigkeit von dem Audiosignal moduliert werden. Diese Modulation bewirkt, daß das am Audiosignalausgang Audio Out abgenommene Audiosignal mit Klirren behaftet ist.

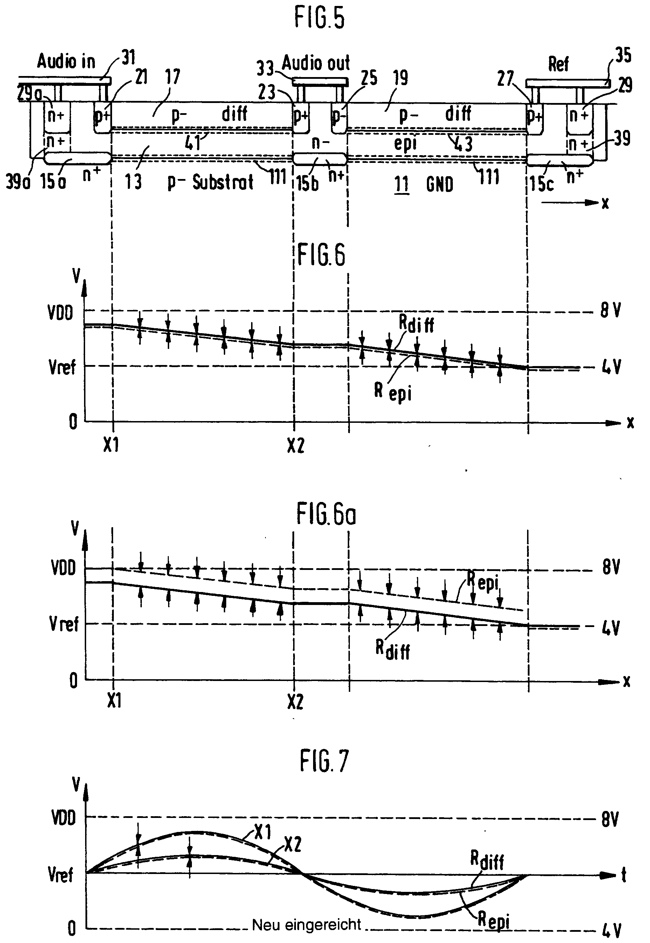

Fig. 5 zeigt eine Schnittansicht einer erfindungsgemäßen Widerstandskette mit zwei diffundierten Nutzwiderständen und einem epitaktischen Hilfswiderstand. Die in Fig. 5 gezeigte Halbleiterstruktur stimmt zu einem großen Teil mit der in Fig. 2 gezeigten Halbleiterstruktur überein und für gleiche Strukturelemente werden in Fig. 5 die gleichen Bezeichnungen und Bezugsziffern wie in Fig. 2 verwendet. Der wesentliche Unterschied der erfindungsgemäßen Struktur in Fig. 5 gegenüber der herkömmlichen Struktur in Fig. 2 besteht in folgenden Abweichungen:

Die Epitaxietasche 13 weist zusätzlich zu der Anschlußkontaktzone 29 auf ihrer in Fig. 5 rechten Seite eine zweite Anschlußkontaktzone 29a auf ihrer in Fig. 5 linken Seite auf. Die beiden Anschlußkontaktzonen 29a und 29 sind gemeinsam mit der jeweils benachbarten Anschlußkontaktzone 21 bzw. 27 der ersten Widerstandszone 17 bzw. der zweiten Widerstandszone 19 mit der metallischen Leiterbahn 31 bzw. 35 verbunden und damit gemeinsam an den Audiosignaleingang Audio In bzw. die Referenzspannung Vref angeschlossen. Es ist keine sich über die gesamte Epitaxietasche 13 erstreckende vergrabene Schicht 15 vorgesehen. Es sind nur einzelne Teile von vergrabenen Schichten 15a, 15b und 15c vorgesehen, die sich unterhalb der Anschlußkontaktzonen 29a und 21 bzw. 23 und 25 bzw. 27 und 29 und den dazwischen befindenden Teilen der Epitaxietasche 13 befinden. Unterhalb der Widerstandszonen 17 und 19 gibt es keine vergrabenen Schichten. Die Anschlußkontaktzonen 21, 23, 25 und 27 bilden Nutzwiderstandsanschlußkontaktzonen, während die Anschlußkontaktzonen 29 und 29a Hilfswiderstandsanschlußkontaktzonen bilden.

Die Folge dieser Halbleiterstruktur ist, daß nicht nur die beiden diffundierten Widerstandszonen 17 und 19 als Widerstandsstrecken wirken sondern auch die zwischen den Bereichen mit vergrabener Schicht 15a, 15b und 15c befindlichen Teile der Epitaxietasche 13.

Während die Widerstandszonen 17 und 19 Nutzwiderstände der Widerstandskette bilden, stellen die Teile der Epitaxietasche 13 ohne vergrabene Schicht den Hilfswiderstand dar. Da die beiden jeweils benachbarten Endanschlüsse der Nutzwiderstandskette und des Hilfswiderstandes an das gleiche Potential angeschlossen sind, ist der gesamte Spannungsabfall über der Nutzwiderstandskette einerseits und dem Hilfswiderstand andererseits gleich groß. Durch den sehr geringen Widerstand der vergrabenen Schicht ist der Spannungsabfall in der Epitaxietasche 13 in den Bereichen, in denen die vergrabene Schicht vorhanden ist, vernachlässigbar gering und findet demzufolge fast nur in den Teilen der Epitaxietasche 13 statt, in denen keine vergrabene Schicht vorhanden ist.

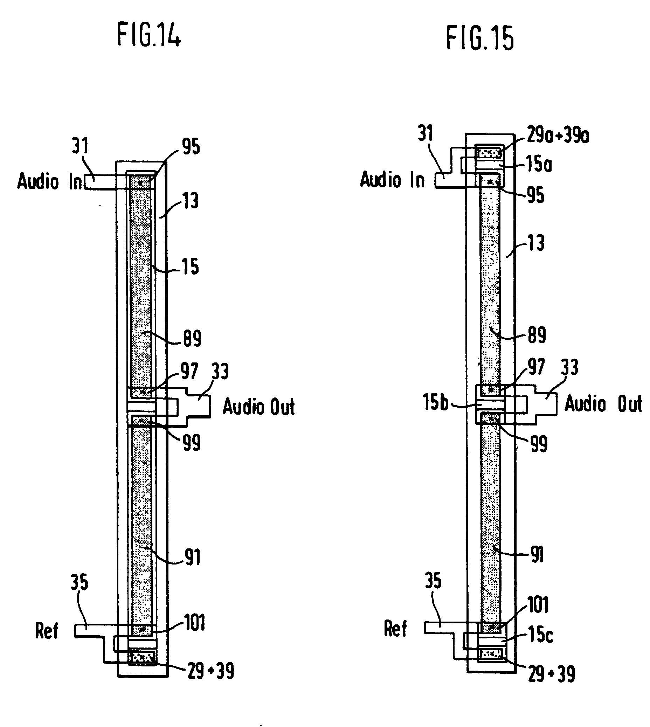

Erfindungsgemäß ist zusätzlich vorgesehen, daß die Nutzwiderstandszonen 17 und 19 einerseits und die Hilfswiderstandszone 13 andererseits übereinstimmende Topographien aufweisen, wie dies anhand der Fig. 14 - 18 noch näher erläutert werden wird. Diese Topographieübereinstimmung führt dazu, daß über der Nutzwiderstandskette und über dem Hilfswiderstand nicht nur ein gleicher Spannungsbetrag abfällt sondern daß die Spannungsabfallverläufe entlang der beiden Nutzwiderstandszonen 17 und 19 einerseits und entlang der Hilfswiderstandszone 13 andererseits eine annähernd gleiche Verlaufsform haben. Dies ist in Fig. 6 dargestellt, wobei der mit durchgezogener Linie dargestellte Spannungsabfallverlauf Rdiff den Spannungsabfall entlang der beiden diffundierten Nutzwiderstände und der gestrichelt dargestellte Spannungsabfallverlauf Repi den Spannungsabfallverlauf entlang des Hilfswiderstandes darstellen. Beide Spannungsabfälle haben im Idealfall identischen Verlauf und liegen auch in der Praxis dicht zusammen, was sich zeichnerisch jedoch nur schlecht darstellen läßt.
Fig. 6a zeigt den verschobenen Spannungsabfallverlauf des Hilfswiderstands bei Verwendung von Gleichspannungsquellen zwischen den jeweils benachbarten Endanschlußkontakten von Nutzwiderstandskette und Hilfswiderstand gemäß Fig. 1b.

Fig. 7 zeigt ein Wechselspannungssignal ähnlich Fig. 4, jedoch nur an zwei Stellen x1 und x2 entlang der Widerstandskette in Fig. 5. Diese Figur zeigt, daß auch bei Beaufschlagung der Widerstandskette mit einer Wechselspannung über den einzelnen Punkten entlang der beiden Raumladungszonen 41 und 43 immer gleiche Potentialdifferenz auftritt, es somit, von Abweichungen im Spannungsabfallverlauf des Hilfswiderstandes abgesehen, nicht zu einer Modulation der Raumladungszonen und damit der Nutzwiderstände kommt.

Bei exakter Topographieübereinstimmung von Nutzwiderstandszonen und Hilfswiderstandszone fallen die beiden Spannungsabfallverläufe Rdiff und Repi fast zusammen. Lediglich der Spannungsabfallverlauf im Hilfswiderstand wird durch den gleichen Effekt, nämlich die der Modulation der Weite der isolierenden Raumladungszone Nr. 111 in Fig. 5 zwischen Hilfswiderstand und dem darunter liegenden Substrat, moduliert. Die resultierende Spannungsabhängigkeit des Spannungsabfallverlaufes des Hilfswiderstandes ist jedoch ähnlich gering wie bei herkömmlichen Widerständen, und wirkt sich im Nutzwiderstand kaum noch aus. Das bedeutet, daß einerseits an allen Stellen entlang der pn-Übergänge immer die annähernd gleiche Potentialdifferenz auftritt und daß andererseits bei Beaufschlagung der Widerstandskette mit einem Audio-Wechselsignal zu allen Zeiten und an allen Stellen entlang der beiden pn-Übergänge immer die annähernd gleiche Potentialdifferenz auftritt. Es kommt daher kaum noch zu Änderungen und zu einer Modulation der Raumladungszonen 41 und 43. Die integrierten Widerstände können, im Falle von Audioanwendungen, daher kaum noch Klirren verursachen oder haben kaum noch eine Spannungsabhängigkeit im Falle von Gleichspannungsanwendungen.

Bei praktischen Ausführungsformen von Halbleiterschaltungen wird es zu bestimmten Abweichungen der Topographien von Nutzwiderstandszonen und Hilfswiderstandszone kommen. Dies hat zur Folge, daß die beiden Spannungsabfallverläufe Rdiff und Repi nicht mehr ganz so gut zusammenfallen sondern gewisse Abweichungen voneinander haben. Dies und Potentialdifferenz durch die Modulation im Hilfswiderstand führen dazu, daß auch eine erfindungsgemäß gestaltete Widerstandskette noch einen gewissen Klirrfaktor verursacht, der jedoch wesentlich kleiner ist als bei einer entsprechenden Widerstandskette herkömmlicher Art. Da das am Audiosignalausgang Audio Out abgenommene Audiosignal üblicherweise dem Eingang eines Operationsverstärkers zugeführt wird, der seinerseits einen Klirrfaktor bestimmter Größe verursacht, der bei praktischen Ausführungsformen im Bereich von 0,0005 % bei 1Vrms liegt, ist es nicht erforderlich, den von der Widerstandskette verursachten Klirrfaktor deutlich unter diesen Wert zu bringen. Es können somit gewisse Topographieunterschiede zwischen den Nutzwiderstandszonen und der Hilfswiderstandszone toleriert werden.

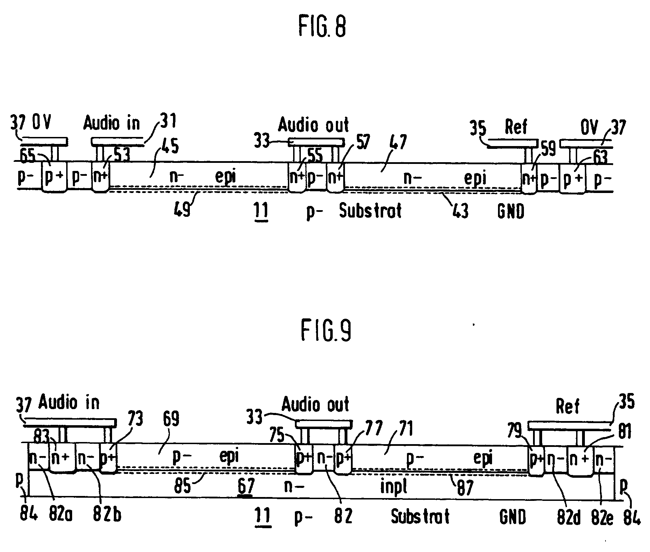

Die Fig. 8 und 9 zeigen je eine Schnittansicht einer Widerstandskette mit zwei epitaktischen Widerständen herkömmlicher Art bzw. erfindungsgemäßer Art.

Die herkömmliche Widerstandskette gemäß Fig. 8 weist zwei epitaktische Widerstände auf, die durch zwei epitaktische Widerstandszonen 45 und 47 mit n⁻-Leitfähigkeit gebildet sind, die sich auf der Oberfläche eines Substrates 11 mit p⁻-Leitfähigkeit befinden. Die epitaktischen Widerstandszonen 45 und 47 sind mit Anschlußkontaktzonen 53, 55, 57 und 59 versehen, die je n⁺-Leitfähigkeit besitzen. Diese Anschlußkontaktzonen sind mit den bereits im Zusammenhang mit Fig. 2 erläuterten metallischen Leiterbahnen 31, 33 bzw. 35 verbunden. Das Substrat 11 weist mindestens eine Anschlußkontaktierungszone 63 mit p⁺-Leitfähigkeit auf, der über die metallische Leiterbahn 37 Massepotential, beispielsweise 0 Volt, zugeführt wird. Es kann auch mindestens eine weitere Anschlußkontaktierungszone 65 für das Substrat 11 vorgesehen sein, die dann ebenfalls mit der metallischen Leiterbahn 37 verbunden ist. Zwischen den epitaktischen Widerstandszonen 45, 47 und dem Substrat 11 bestehen pn-Übergänge, in deren Bereich sich Raumladungszonen 49 und 51 bilden.

Aus den gleichen Gründen, wie sie im Zusammenhang mit den Fig. 2 bis 4 erläutert worden sind, kommt es auch bei derartigen epitaktischen Widerständen zu einer Abhängigkeit der an den Raumladungszonen 49 und 51 wirkenden Potentialdifferenz und damit zu einer Abhängigkeit der epitaktischen Widerstände von der jeweils angelegten Spannung und zu einer Modulation der Widerstände beim Anlegen einer Wechselspannung an die Widerstände. Der einzige Unterschied ist, daß dann, wenn man die Fig. 3 und 4 im Zusammenhang mit den Widerständen der Fig. 8 betrachtet, die vertikalen Pfeile nicht nach VDD sondern nach GND (0 Volt) zu richten sind, weil im Fall der Fig. 8 an der metallischen Leiterbahn 37 nicht VDD anliegt sondern 0 V (GND).

Bei der in Fig. 9 gezeigten erfindungsgemäßen Widerstandskette sind als Nutzwiderstandszonen epitaktische Widerstandszonen 69 und 71 mit p-Leitfähigkeit vorgesehen, die nicht auf dem Substrat 11 direkt gebildet sind sondern auf einer in die Substratoberfläche eingebrachten Zone 67 mit n⁻-Leitfähigkeit, die als Hilfswiderstandszone dient. Diese Hilfswiderstandszone kann durch Epitaxie, Diffusion oder durch Ionenimplantation erzeugt worden sein. Die Nutzwiderstandszonen 69 und 71 und deren p⁺ Anschlußkontaktzonen 73, 75, 77 und 79 werden dabei mit n⁻-Gebieten isoliert 82a bis 82e isoliert. Die Hilfswiderstandszone 67 kann dabei mit p-Gebieten 84', die bis in das p⁻-Substrat hinabreichen isoliert werden.

In gleicher Weise wie in Fig. 8 sind die epitaktischen Nutzwiderstandszonen 69 und 71 in Fig. 9 mit je zwei Anschlußkontaktzonen 73 und 75 bzw. 77 und 79 versehen, die im Fall der Fig. 9 p⁺-Leitfähigkeit haben. Die Hilfswiderstandszone 67 ist mit zwei Anschlußkontaktzonen 81 und 83 mit n⁺-Leitfähigkeit versehen. Die Anschlußkontaktzonen 73 und 83 sind über die metallische Leiterbahn 37 gemeinsam an den Audiosignaleingang Audio in angeschlossen. Wie im Fall der Fig. 8 sind die beiden Anschlußkontaktzonen 75 und 77 über die metallische Leiterbahn 33 mit dem Audiosignal Audio out verbunden. Die restlichen beiden Anschlußkontaktzonen 79 und 81 sind über die metallische Leiterbahn 35 gemeinsam an die Referenzspannungsquelle Ref angeschlossen.

Die Anschlußkontaktzonen 73, 75, 77 und 79 bilden Nutzwiderstandsanschlußkontaktzonen, während die Anschlußkontaktzonen 81 und 83 Hilfswiderstandsanschlußkontaktzonen bilden.

An den pn-Übergängen zwischen den epitaktischen Nutzwiderstandszonen 69 und 71 und der epitaktischen, diffundierten oder implantierten Hilfswiderstandszone 67 bilden sich Raumladungszonen 85 bzw. 87, an denen aus den Gründen, wie sie im Zusammenhang mit den Fig. 5 - 7 erläutert sind, gleichbleibende oder im wesentlichen gleichbleibende Potentialdifferenzen auftreten, und zwar sowohl räumlich entlang der Nutzwiderstandszonen 69 und 71 als auch zeitlich bei Beaufschlagung der Widerstände mit einer Wechselspannung. Auch in diesem Fall kommt es daher im Audiosignalbetrieb zu einer entsprechenden Klirrfaktorverringerung.

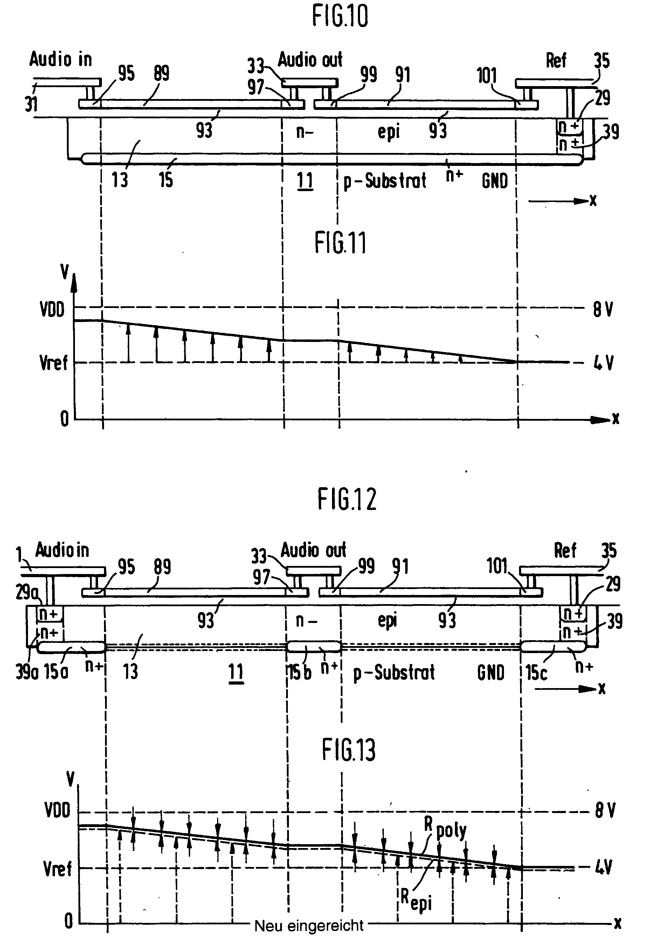

Anhand der Fig. 10 - 13 werden nun Widerstandsketten mit zwei polykristallinen Widerständen herkömmlicher Art und erfindungsgemäßer Art betrachtet.

Die in Fig. 10 gezeigte Widerstandskette mit zwei herkömmlichen Widerständen aus polykristallinem Silizium weist in Übereinstimmung mit der in Fig. 2 gezeigten Halbleiterstruktur eine auf einem Substrat 11 mit p⁻-Leitfähigkeit gebildete Epitaxietasche 13 mit n⁻-Leitfähigkeit und mit einer vergrabenen Schicht 15 mit n⁺-Leitfähigkeit auf. Im Unterschied zu der in Fig. 2 gezeigten Halbleiterstruktur sind bei der in Fig. 10 gezeigten Widerstandskette die beiden Widerstände durch zwei polykristalline Widerstandszonen 89 und 91 gebildet, also durch je eine polykristalline Siliziumschicht. Zwischen den polykristallinen Widerstandszonen 89, 91 und der Epitaxietasche 13 befindet sich eine elektrisch isolierende Schicht, üblicherweise eine Oxidschicht 93.

Die beiden polykristallinen Widerstandszonen 89 und 91 sind an ihren Enden mit Nutzwiderstandsanschlußkontaktzonen bildenden Anschlußkontaktzonen 95, 97, 99 bzw. 101 versehen, mittels welchen sie an die metallischen Leiterbahnen 31, 33 und 35 angeschlossen und damit mit dem Audiosignaleingang Audio In, dem Audiosignalausgang Audio Out bzw. der Referenzspannungsquelle Ref verbunden sind. Die vergrabene Schicht 15 der Epitaxietasche 13 ist über eine Anschlußkontaktzone 29 und einen Sinker 39 ebenfalls an die metallische Leiterbahn 35 angeschlossen und wird daher ebenfalls mit der Referenzspannung Vref der Referenzspannungsquelle Ref beaufschlagt.

Über die Oxidschicht 93 stehen die polykristallinen Widerstandszonen 89, 91 unter Beinflussung der jeweiligen Potentialdifferenz zwischen polykristalliner Widerstandszone 89, 91 und Epitaxietasche 13. Dies führt zu einer Ladungsträgerkonzentration innerhalb des dem Oxid 93 benachbarten Unterseite der polykristallinen Widerstandszonen 89 und 91, die sich in Abhängigkeit von der genannten Potentialdifferenz ändert. Dies führt auch im Fall von polykristallinen Widerständen zu einer Beeinflussung des Widerstandswertes und zur Verursachung von Klirren im Fall der Beaufschlagung dieser Widerstände mit Wechselspannung.

Fig. 11 zeigt den Spannungsabfallverlauf entlang der polykristallinen Widerstände der Fig. 10. Die feldstärkeabhängige Beeinflussung des der Oxidschicht 93 benachbarten Bereichs der jeweiligen polykristallinen Widerstandszone 89 bzw. 91 hängt von der jeweiligen Differenzspannung ab, wie sie in Fig. 11 mit vertikalen Pfeilen angedeutet ist. Die feldstärkeabhängige Beeinflußung der polykristallinen Widerstände mit einer Wechselspannung gelten die gleichen Überlegungen, wie sie im Zusammenhang mit Fig. 4 dargelegt worden sind.

Die feldstärkeabhängige Beeinflussung der polykristallinen Widerstände ist zwar geringer als die Beeinflussung der diffundierten Widerstände und der epitaktischen Widerstände über deren Raumladungszonen, weswegen mit polykristallinen Widerständen herkömmlicher Art geringere Klirrfaktoren erreicht werden können als mit diffundierten Widerständen und epitaktischen Widerständen herkömmlicher Art. Durch Anwendung der erfindungsgemäßen Maßnahmen bei polykristallinen Widerständen kann jedoch noch eine weitere Verringerung des Klirrfaktors erreicht werden.

Die in Fig. 12 gezeigte Halbleiterstruktur einer erfindungsgemäßen Widerstandskette mit zwei polykristallinen Widerständen stimmt mit der in Fig. 10 gezeigten Halbleiterstruktur mit den Ausnahmen überein, daß - wie im Fall der Fig. 5 - die Epitaxietasche 13 als Hilfswiderstandszone ausgebildet ist, welche vergrabene Schichten 15a, 15b und 15c nur außerhalb der polykristallinen Widerstandszonen 89 und 91 aufweist. Außerdem ist die epitaktische Hilfswiderstandszone 13 auch auf ihrer in Fig. 12 linken Seite mit einer Anschlußkontaktzone 29a verbunden, die an die metallische Leiterbahn 31 angeschlossen und damit mit dem Audiosignaleingang Audio In verbunden ist. Die Anschlußkontaktzone 29a ist über einen Sinker 39a mit der vergrabenen Schicht 15a verbunden.

Wie bei den in den Fig. 5 und 9 gezeigten Ausführungsformen der Erfindung gilt auch im Fall der Fig. 12, daß die polykristallinen Widerstandszonen 89 und 91 insgesamt und die darunter befindliche epitaktische Hilfswiderstandszone 13 übereinstimmende Topographie aufweisen. Aus diesem Grund und weil die epitaktische Hilfswiderstandszone 13 den in Reihe geschalteten polykristallinen Nutzwiderstandszonen 89 und 91 parallelgeschaltet ist, kommt es entlang der Nutzwiderstandszonen und entlang der Hilfswiderstandszone zu gleichförmigen Spannungsabfallverläufen und der in Fig. 13 gezeigte Spannungsabfallverlauf gilt daher sowohl für die polykristallinen Nutzwiderstände als auch annähernd für den epitaktischen Hilfswiderstand. Bei idealer Topographieübereinstimmung von Nutzwiderständen und Hilfswiderstand gibt es daher keine Widerstandsbeeinflussung in Abhängigkeit von dem Ort entlang der Widerstandszonen und auch kaum eine Widerstandsmodulation im Fall der Beaufschlagung der Widerstände mit einem Wechselspannungssignal. Lediglich die Modulation der Raumladungszone 111 in Fig. 12 zwischen Hilfswiderstand und Substrat erzeugt eine leichte Abweichung im Spannungsabfallverlauf des Hilfswiderstandes vom Spannungsabfallverlauf der Nutzwiderstandskette. Die den Hilfswiderstand modulierende Spannung ist in Fig. 13 mit gestrichelten Pfeilen angedeutet.

Anstatt polykristallinen Siliziums kann man für die Nutzwiderstandszonen 89 und 91 auch Silizium-Chrom oder ähnliche Materialien verwenden.

Topographiebeispiele für erfindungsgemäße Widerstandsketten mit polykristallinen Widerständen werden nun anhand der Fig. 14 - 18 erläutert. Dabei zeigen die Fig. 14 und 15 Topographiebeispiele der in den Fig. 10 und 12 gezeigten Widerstandsketten. Anders als bei Fig. 14, ist in Fig. 15 im Bereich der polykristallinen Nutzwiderstandszonen 89 und 91 keine vergrabene Schicht 15 vorhanden. Kurze Stücke 15a, 15b und 15c einer vergrabenen Schicht befinden sich lediglich im Bereich der Anschlußkontaktzonen. Die metallischen Leiterbahnen 31 und 35 sind gegenüber Fig. 14 so modifiziert, daß sie die benachbarten Anschlußkontaktzonen 29 und 101 bzw. 29a und 95 miteinander verbinden.

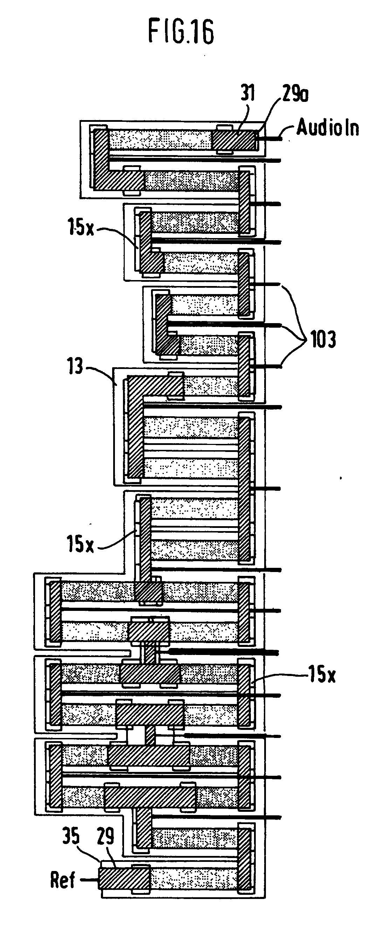

Ein Topographiebeispiel einer erfindungsgemäß ausgestalteten komplexeren Widerstandskette ist in Fig. 16 gezeigt. Dabei sind metallische Leiterbahnen vollflächig schwarz dargestellt. Rechts oben in Fig. 16 befindet sich die metallische Leiterbahn 31 für die Verbindung mit dem Audiosignaleingang Audio In. Etwa links unten in Fig. 16 befindet sich die metallische Leiterbahn 35 zum Anschluß an die Referenzspannungsquelle Ref. Die metallischen Leiterbahnen 103 sind je über nicht dargestellte Schalter mit dem Audiosignalausgang "Audio Out" verbunden, und entsprechen den Teilspannungsabgriffen A1, A2, ... in Fig. 1

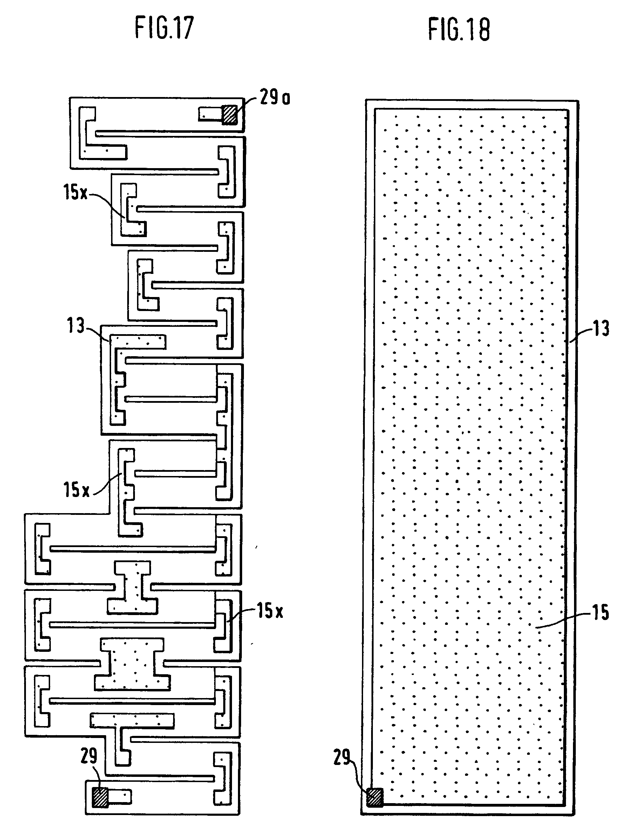

In Fig. 17 ist die Topographie der den epitaktischen Hilfswiderstand bildenden Epitaxietasche 13 mit den einzelnen kurzen Stücken von vergrabenen Schichten 15x gesondert dargestellt. Im Vergleich dazu ist in Fig. 18 die Topographie einer Epitaxietasche 13 mit großflächiger vergrabener Schicht 15 gezeigt, wie sie bei Ausgestaltung einer herkömmlichen Widerstandskette mit der in Fig. 16 gezeigten Topographie verwendet würde.

Mit einer erfindungsgemäßen Widerstandskette mit polykristallinen Nutzwiderständen und einem epitaktischen Hilfswiderstand läßt sich der von der Nutzwiderstandskette verursachte typische Klirrfaktor von 0,004 % auf deutlich unter 0,001 % (bei 1Vrms und -6 dB Dämpfung), und damit den Bereich des Klirrfaktors praktisch realisierter Operationsverstärker, verringern. Der von einer erfindungsgemäßen Widerstandskette noch verursachte Klirrfaktor hängt im wesentlichen von der Genauigkeit der Topographieübereinstimmung von Nutzwiderständen und Hilfswiderstand ab.

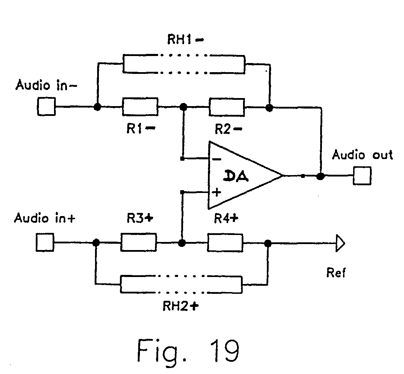

Das erfindungsgemäße Prinzip, zwei in ihrer Topographie im wesentlichen übereinstimmende Widerstände in übereinanderliegenden Halbleitermaterialien anzuordnen, kann auch für Differenzstufen verwendet werden. Ein Beispiel hierfür zeigt Fig. 19 mit einem Differenzverstärker DA, der einen invertierenden Anschluß -, einen nichtinvertierenden Anschluß + und einen Ausgang, welcher einen Audiosignalausgang Audio out bildet, aufweist. Eine erste Nutzwiderstandskette mit zwei Nutzwiderständen R1- und R2- ist zwischen einen ersten Audiosignaleingang Audio in - und Audio out geschaltet, während eine zweite Nutzwiderstandskette R3+ und R4+ zwischen einen zweiten Audiosignaleingang Audio in+ und Audio out geschaltet ist. Ein Verbindungspunkt zwischen R1- und R2- ist mit dem invertierenden Eingang - und ein Verbindungspunkt zwischen R3+ und R4+ ist mit dem nichtvertierenden Eingang + verbunden. Den beiden Widerstandsketten R1-, R2- und R3+, R4+ ist je ein erfindungsgemäßer Hilfswiderstand RH1- bzw. RH2 + zugeordnet.

## Patentansprüche

1. In einer integrierten Halbleiterschaltung integrierter elektrischer Widerstand, aufweisend:
einen Nutzwiderstand mit zwei voneinander beabstandeten Nutzwiderstandsanschlußkontaktzonen (21, 27; 73, 75; 95, 101) und einer dazwischen befindlichen Nutzwiderstandszone (17, 19; 69, 71; 89, 91) aus Halbleitermaterial;
und einen Hilfswiderstand mit zwei voneinander beabstandeten Hilfswiderstandsanschlußkontaktzonen (29, 29a; 81, 83) und einer dazwischen befindlichen Hilfswiderstandszone (13; 67);
wobei:
die Hilfswiderstandszone (13; 67) in unterhalb der Nutzwiderstandszone (17, 19; 69, 71; 89, 91) befindlichem Halbleitermaterial gebildet ist;
zwischen Nutzwiderstandszone (17, 19; 69, 71; 89, 91) und Hilfswiderstandszone (13; 67) eine Zwischenzone (41; 43; 85; 93) vorhanden ist;
die Nutzwiderstandszone (17, 19; 69, 71; 89, 91) und die Hilfswiderstandszone (13; 67) eine im wesentlichen übereinstimmende Topographie aufweisen;
und die Hilfswiderstandsanschlußkontaktzonen (29, 29a; 81, 83) und die Nutzwiderstandsanschlußkontaktzonen (21, 27; 73, 79; 95, 101) derart beschaltet sind, daß bei Anschluß der Halbleiterschaltung an eine Versorgungsspannungsquelle die Hilfswiderstandsanschlußkontaktzone (29; 81) an einem Ende der Hilfswiderstandszone (13; 67) und die Hilfswiderstandsanschlußkontaktzone (29a; 83) am anderen Ende der Hilfswiderstandszone (13; 67) je die gleiche Potentialdifferenz gegenüber der je benachbarten Nutzwiderstandsanschlußkontaktzone (21, 27; 73, 79; 95, 101) aufweisen.

2. Widerstand nach Anspruch 1, bei welchem die Potentialdifferenz null ist.

3. Widerstand nach Anspruch 2, bei welchem die Hilfswiderstandsanschlußkontaktzonen (29, 29a; 81, 83) an die je benachbarten Nutzwiderstandsanschlußkontaktzonen (21, 27; 73, 79; 95, 101) angeschlossen sind.

4. Widerstand nach Anspruch 1, bei welchem zwischen jede der Hilfswiderstandsanschlußkontaktzonen (29, 29a; 81, 83) und die je benachbarte Nutzwiderstandsanschlußkontaktzone (21, 27; 73, 79; 95, 101) je eine Gleichspannungsquelle (112a, 112b) gleichen Spannungswertes geschaltet ist.

5. Widerstand nach Anspruch 1 oder 2, bei welchem zu jeder der Hilfswiderstandsanschlußkontaktzonen (29, 29a; 81, 83) ein Spannungsfolger (113a, 113b) in Reihe geschaltet ist.

6. Widerstand nach einem der Ansprüche 1 bis 5, bei welchem die Hilfswiderstandszone (13) durch eine auf einem Halbleitersubstrat (11) gebildete Epitaxieschicht eines ersten Leitfähigkeitstyps gebildet ist.

7. Widerstand nach Anspruch 6, bei welchem die Nutzwiderstandkontaktierungszonen (21, 27; 95, 101) hohe Leitfähigkeit aufweisen und in unterhalb der Nutzwiderstandszone (17, 19; 89, 91) befindlichen Bereichen der Epitaxieschicht (13) je eine vergrabene Schicht (15a, 15b, 15c) hoher Leitfähigkeit gebildet ist, deren Topographie in etwa mit der Topographie der je zugehörigen Nutzwiderstandsanschlußzone (21, 27; 95, 101) übereinstimmt.

8. Widerstand nach Anspruch 7, bei welchem sich im Bereich der Hilfswiderstandsanschlußkontaktzonen (29, 29a) befindliche vergrabene Schichten (15a, 15c) bis unter die jeweilige Hilfswiderstandsanschlußkontaktzone (29, 29a) erstrecken.

9. Widerstand nach Anspruch 8, bei welchem jede der Hilfswiderstandsanschlußkontaktzonen (29, 29a) mit der je zugehörigen vergrabenen Schicht (15a, 15c) über einen Sinker (39) verbunden ist.

10. Widerstand nach Anspruch 6 oder 7, bei welchem die Nutzwiderstandszone (89, 91) durch eine Schicht gebildet ist, die aus einer polykristallinen Silizium und Silizium-Chrom enthaltenden Materialgruppe ausgewählt ist, sich über der Epitaxieschicht (13) befindet und von dieser durch eine Zwischenzone in Form einer Oxidschicht (93) getrennt ist.

11. Widerstand nach Anspruch 6 oder 7, bei welchem die Nutzwiderstandszone (17, 19) durch eine in die Oberfläche der Epitaxieschicht (13) diffundierte Diffusionszone gebildet ist, welche einen dem Leitfähigkeitstyp der Epitaxieschicht (13) entgegengesetzten Leitfähigkeitstyp aufweist und von der Epitaxieschicht (13) durch ein Zwischenzone in Form einer pn-Raumladungszone (41, 43) getrennt ist.

12. Widerstand nach Anspruch 6 oder 7, bei welchem die Nutzwiderstandszone durch eine auf der ersten Epitaxieschicht (13) gebildete zweite Epitaxieschicht gebildet ist, welche einen dem ersten Leitfähigkeitstyp entgegengesetzten zweiten Leitfähigkeitstyp aufweist und von der ersten Epitaxieschicht (13) durch eine Zwischenzone in Form einer pn-Raumladungszone getrennt ist.

13. Widerstand nach einem der Ansprüche 1 bis 5, bei welchem die Hilfswiderstandszone (67) in einer Dotierungszone eines ersten Leitfähigkeitstyps gebildet ist, die sich in einem Substrat (11) eines entgegengesetzten zweiten Leitfähigkeitstpys befindet, und bei welchem die Nutzwiderstandszone (69, 71) durch eine auf der Dotierungszone (67) gebildete Epitaxieschicht des zweiten Leitfähigkeitstyps gebildet ist.

14. In einer integrierten Halbleiterschaltung gebildete Widerstandskette mit einer vorbestimmten Anzahl in Reihenschaltung miteinander verbundener Widerstände (R1 - R6) und mit Endanschlußkontakten (E A) an den beiden Enden der Widerstandskette und mit Abgriffskontakten (A1 - A5) zwischen den einzelnen Widerständen,
wobei:
jeder Widerstand (R1 - R6) einen Nutzwiderstand mit zwei voneinander beabstandeten Nutzwiderstandsanschlußkontaktzonen (21, 23, 25, 27; 73, 75, 77, 79; 95, 97, 99, 101) und einer dazwischen befindlichen Nutzwiderstandszone (17, 19; 69, 71; 89, 91) aus Halbleitermaterial aufweist;
ein Hilfswiderstand mit zwei voneinander beabstandeten Hilfswiderstandskontaktzonen (29, 29a; 81, 83) und einer dazwischen befindlichen Hilfswiderstandszone (13; 67) vorgesehen ist;
die Hilfswiderstandszone (13; 67) in unterhalb der Nutzwiderstandszonen (17, 19; 69, 71; 89, 91) befindlichem Halbleitermaterial gebildet ist;
zwischen den Nutzwiderstandszonen (17, 19; 69, 71; 89, 91) und der Hilfswiderstandszone (13; 67) Zwischenzonen (41, 43; 85, 87; 93) vorhanden sind;
die Nutzwiderstandszonen (17, 19; 69, 71; 89, 91) insgesamt einerseits und die Hilfswiderstandszone (13; 67) andererseits eine im wesentlichen übereinstimmende Topographie aufweisen;
und die die Endanschlußkontakte (E, A) bildenden Nutzwiderstandsanschlußkontaktzonen (21, 27; 73, 79; 95, 101) und die Hilfswiderstandsanschlußkontaktzonen (29a, 29; 83, 81) derart beschattet sind, daß bei Anschluß der Halbleiterschaltung an eine Versorgungsspannungsquelle die Hilfswiderstandsanschlußkontaktzone (29; 81) an einem Ende der Hilfswiderstandszone (13 ; 67) und die Hilfswiderstandsanschlußkontaktzone (29a; 83) am anderen Ende der Hilfswiderstandszone (13; 67) je die gleiche Potentialdifferenz gegenüber der je benachbarten Nutzwiderstandsanschlußkontaktzone (21, 23, 25, 27; 73, 79; 95, 97, 99, 101) aufweisen.

15. Widerstandskette nach Anspruch 14, bei welchem die Potentialdifferenz null ist.

16. Widerstandskette nach Anspruch 15, bei welchem die Hilfswiderstandsanschlußkontaktzonen (29, 29a; 81, 83) an die je benachbarten Nutzwiderstandsanschlußkontaktzone (21, 23, 25, 27; 73, 79; 95, 97, 99, 101) angeschlossen sind.

17. Widerstandskette nach Anspruch 14, bei welchem zwischen jede der Hilfswiderstandsanschlußkontaktzonen (29, 29a; 81, 83) und die je benachbarte Nutzwiderstandsanschlußkontaktzone (21, 23, 25, 27; 73, 79; 95, 97, 99, 101) je eine Gleichspannungsquelle (112a, 112b) gleichen Spannungswertes geschaltet ist.

18. Widerstandskette nach Anspruch 14 oder 15, bei welchem zu jeder der Hilfswiderstandsanschlußkontaktzone (29, 29a; 81, 83) ein Spannungsfolger (113a, 113b) in Reihe geschaltet ist.

19. Widerstandskette nach einem der Ansprüch 14 bis 18, bei welcher die Hilfswiderstandszone (13) durch eine auf einem Halbleitersubstrat (11) gebildete Epitaxieschicht eines ersten Leitfähigkeitstyps gebildet ist.

20. Widerstandskette nach Anspruch 19, bei welcher in den Nutzwiderstandszonen (17, 19; 89, 91) im Bereich der Nutzwiderstandsanschlußkontakte Nutzwiderstandsanschlußkontaktzonen (21, 23, 25, 27; 95, 97, 99, 101) gebildet sind und in unterhalb der Nutzwiderstandsanschlußkontaktzonen (21, 23, 25, 27; 95, 97, 99, 101) befindlichen Bereichen der als Hilfswiderstand genutzten Epitaxieschicht (13) je eine vergrabene Schicht (15a, 15b, 15c) hoher Leitfähigkeit gebildet ist, deren Topographie in etwa mit der Topographie der je zugehörigen Nutzwiderstandsanschlußkontaktzone (21, 23, 25, 27; 95, 97, 99, 101) übereinstimmt.

21. Widerstandskette nach Anspruch 19 oder 20, bei welcher die Nutzwiderstandszonen (89, 91) je durch eine Schicht aus polykristallinem Silizium gebildet sind, die aus einer polykristallinen Silizium und Silizium-Chrom enthaltenden Materialgruppe ausgewählt ist, sich über der Epitaxieschicht (13) befinden und von dieser durch eine Zwischenzone in Form einer Oxidschicht (93) getrennt sind.

22. Widerstandskette nach Anspruch 19 oder 20, bei welcher die Nutzwiderstandszonen (17, 19) durch in die Oberfläche der Epitaxieschicht (13) diffundierte oder implantierte Zonen gebildet sind, welche einen dem Leitfähigkeitstyp der Epitaxieschicht (13) entgegengesetzten Leitfähigkeitstyp aufweisen und von der Epitaxieschicht (13) durch Zwischenzonen in Form von pn-Raumladungszonen (41, 43) getrennt sind.

23. Widerstandskette nach einem der Ansprüche 19 bis 20, bei welcher im Bereich der Abgriffskontakte (A1 - A5; 33) zwischen benachbarten Nutzwiderstandszonen (17, 19; 69, 71; 89, 91) Nutzwiderstandszonenlücken bestehen und die Hilfswiderstandszone (13) an den Stellen der einzelnen Nutzwiderstandszonenlücken je eine vergrabene Schicht (15a, 15b, 15c) hoher Leitfähigkeit aufweist, wobei die vergrabenen Schichten (15a, 15b, 15c) und die je zugehörigen Nutzwiderstandszonenlücken eine im wesentlichen übereinstimmende Topographie aufweisen.

24. Widerstandskette nach Anspruch 23, bei welchem sich im Bereich der Hilfswiderstandsanschlußkontaktzonen (29, 29a) befindliche vergrabene Schichten (15a, 15c) bis unter die jeweilige Hilfswiderstandsanschlußkontaktzone (29, 29a) erstrecken.

25. Widerstandskette nach Anspruch 24, bei welchem jede der Hilfswiderstandsanschlußkontaktzonen (29, 29a) mit der je zugehörigen vergrabenen Schicht (15a, 15c) über einen Sinker (39) verbunden ist.

26. Widerstandskette nach Anspruch 14, bei welcher die Hilfswiderstandszone (67) in einer Dotierungszone eines ersten Leitfähigkeitstyps gebildet ist, die sich in einem Substrat (11) eines entgegengesetzten zweiten Leitfähigkeitstpys befindet, und bei welchem die Nutzwiderstandszone (69, 71) durch eine auf der Dotierungszone (67) gebildete Epitaxieschichten des zweiten Leitfähigkeitstyps gebildet sind.

27. Analogsignal-Dämpfungsschaltung, mit einer Widerstandskette nach einem der Ansprüche 14 bis 26.

28. Analogsignal-Dämpfungsschaltung nach Anspruch 27, bei welcher ein Audiosignaleingangsanschluß (Audio in) mit einem (E; 31) der beiden Endanschlußkontakte (E, A; 31, 35) verbunden ist, ein Referenzpotentialanschluß (Ref) mit dem anderen Endanschlußkontakt (A; 35) verbunden ist und ein Audiosignalausgang (Audio out) wahlweise mit einem der Abgriffskontakte (A1 - A5; 33) verbindbar ist.

29. Audiosignal-Dämpfungsschaltung nach Anspruch 28, bei welcher der Audiosignalausgang (Audio Out) über je einen steuerbaren Schalter (S1 - S7) mit jedem der Abgriffskontakte (A1 - A5) und mit mindestens dem mit dem Audiosignaleingangsanschluß (Audio in) verbundenen (E) der Endanschlußkontakte (E, A) verbunden ist.
